# FASCICULE DE BREVET EUROPEEN

(11) **EP 2 768 785 B1**
(45) Date de publication et mention de la délivrance du brevet: **10.07.2019**
(21) Numéro de dépôt: 12790591.7
(22) Date de dépôt: 18.10.2012
(51) Int. Cl.: C03C 17/36, H01L 51/52

(54) **PROCEDE DE TRAITEMENT THERMIQUE DE COUCHES D'ARGENT**
VERFAHREN ZUR WÄRMEBEHANDLUNG VON SILBERSCHICHTEN
METHOD OF HEAT TREATMENT OF SILVER LAYERS

(30) Priorité: 18.10.2011 FR 1159389
(43) Date de publication de la demande: 27.08.2014
(73) Titulaire: Saint-Gobain Glass France, 92400 Courbevoie (FR)
(72) Inventeur: LIENHART, Fabien, CA 92108 - San Diego (US); PYTHON, Martin, 1483 Vesin (CH)
(74) Mandataire: Saint-Gobain Recherche
(86) Numéro de dépôt international: PCT/FR2012/052368
(87) Numéro de publication internationale: WO 2013/057428

(56) Documents cités:
- EP-A2- 0 676 379
- WO-A1-2010/142926
- WO-A1-2012/080684
- FR-A1- 2 911 130
- FUJIO TERAI ET AL: "Xenon Flash Lamp Annealing of Poly-Si Thin Films", JOURNAL OF THE ELECTROCHEMICAL SOCIETY, vol. 153, no. 7, 18 mai 2006 (2006-05-18), pages H147-H150, XP055029403, ISSN: 0013-4651, DOI: 10.1149/1.2200291

## Description

L'invention s'intéresse au traitement thermique de couches d'argent déposées sur un substrat.

Les couches d'argent, de par leurs propriétés optiques, notamment de réflexion du rayonnement infrarouge, et/ou de par leurs propriétés de conduction électronique, sont particulièrement appréciées et employées dans des applications très diverses : couches bas-émissives ou de contrôle solaire utilisées dans des vitrages, couches chauffantes pour vitrages chauffants ou radiateurs, ou encore électrodes, par exemple utilisées dans des dispositifs à base de diodes électroluminescentes organiques (dispositifs dits « OLED »).

L'OLED est un dispositif qui émet de la lumière par électroluminescence en utilisant l'énergie de recombinaison de trous injectés depuis une anode et d'électrons injectés depuis une cathode. Il comporte un matériau, ou un empilement de matériaux, électroluminescent(s) organique(s), encadré par deux électrodes, l'une des électrodes, dite inférieure, généralement l'anode, étant constituée par celle associée au substrat et l'autre électrode, dite supérieure, généralement la cathode, étant agencée sur le système électroluminescent organique.

Il existe différentes configurations d'OLED :
- les dispositifs à émission par l'arrière (« bottom emission » en anglais), c'est-à-dire avec une électrode inférieure (semi) transparente et une électrode supérieure réfléchissante ;
- les dispositifs à émission par l'avant (« top emission » en anglais), c'est-à-dire avec une électrode supérieure (semi) transparente et une électrode inférieure réfléchissante ;
- les dispositifs à émission par l'avant et l'arrière, c'est-à-dire avec à la fois une électrode inférieure (semi) transparente et une électrode supérieure (semi) transparente.

Un dispositif OLED trouve généralement son application dans un écran de visualisation ou un dispositif d'éclairage. Les électrodes inférieures doivent présenter la résistivité la plus faible possible, la transmission optique la plus élevée possible, et être particulièrement lisses : une rugosité RMS d'au plus 2 nm, voire 1 nm est souvent nécessaire. On peut utiliser comme électrode un empilement de couches minces électro-conducteur, notamment un empilement comprenant au moins une couche d'argent.

Les couches d'argent sont également fréquemment employées dans des vitrages destinés à améliorer le confort thermique : vitrages bas-émissifs (qui limitent les déperditions de chaleur vers l'extérieur et augmentent par conséquent l'efficacité énergétique des bâtiments qui en sont équipés) ou vitrages de contrôle solaire (qui limitent les entrées de chaleur dans les pièces d'un bâtiment ou dans les habitacles de véhicules automobiles). Ces couches sont par exemple situées en face 2 ou 3 de double-vitrages.

Quelle que soit l'application, et afin notamment d'éviter l'oxydation de l'argent et d'atténuer ses propriétés de réflexion dans le visible, la ou chaque couche d'argent est généralement insérée dans un empilement de couches. La ou chaque couche mince à base d'argent peut être disposée entre deux couches minces diélectriques à base d'oxyde ou de nitrure (par exemple en SnO₂ ou Si₃N₄). Peuvent être également disposées sous la couche d'argent une couche très fine destinée à favoriser le mouillage et la nucléation de l'argent (par exemple en oxyde de zinc ZnO) et sur la couche d'argent une seconde couche très fine (sacrificielle, par exemple en titane) destinée à protéger la couche d'argent au cas où le dépôt de la couche subséquente est réalisé dans une atmosphère oxydante ou en cas de traitements thermiques conduisant à une migration d'oxygène au sein de l'empilement. Ces couches sont respectivement appelées couche de mouillage et couche de bloqueur. Les empilements peuvent également comprendre plusieurs couches d'argent.

Les couches d'argent présentent la particularité de voir leurs résistivité et émissivité améliorées lorsqu'elles sont dans un état au moins partiellement cristallisé. On cherche généralement à augmenter au maximum le taux de cristallisation de ces couches (la proportion massique ou volumique de matière cristallisée) et la taille des grains cristallins (ou la taille de domaines cohérents de diffraction mesurés par des méthodes de diffraction des rayons X).

Il est notamment connu que les couches d'argent présentant un taux de cristallisation élevé et par conséquent une faible teneur résiduelle en argent amorphe présentent une résistivité et une émissivité plus basses ainsi qu'une transmission dans le visible plus élevée que des couches d'argent majoritairement amorphes. La conductivité électrique de ces couches est ainsi améliorée, de même que les propriétés de faible émissivité. L'augmentation de la taille des grains s'accompagne en effet d'une diminution des joints de grains, favorable à la mobilité des porteurs de charge électrique.

Un procédé couramment employé à l'échelle industrielle pour le dépôt de couches minces d'argent, sur substrat verrier ou polymère, est le procédé de pulvérisation cathodique assisté par champ magnétique, appelé procédé « magnétron ». Dans ce procédé, un plasma est créé sous un vide poussé au voisinage d'une cible comprenant les éléments chimiques à déposer, en l'occurrence l'argent. Les espèces actives du plasma, en bombardant la cible, arrachent lesdits éléments, qui se déposent sur le substrat en formant la couche mince désirée. Ce procédé est dit « réactif » lorsque la couche est constituée d'un matériau résultant d'une réaction chimique entre les éléments arrachés de la cible et le gaz contenu dans le plasma. L'avantage majeur de ce procédé réside dans la possibilité de déposer sur une même ligne un empilement très complexe de couches en faisant successivement défiler le substrat sous différentes cibles, ce généralement dans un seul et même dispositif.

Lors de la mise en oeuvre industrielle du procédé magnétron, le substrat reste à température ambiante ou subit une élévation de température modérée (moins de 80°C), particulièrement lorsque la vitesse de défilement du substrat est élevée (ce qui est généralement recherché pour des raisons économiques). Ce qui peut paraître un avantage constitue toutefois un inconvénient dans le cas des couches précitées, car les faibles températures impliquées ne permettent généralement pas une croissance cristalline suffisante. C'est le cas tout particulièrement pour des couches minces de faible épaisseur et/ou des couches constituées de matériaux dont le point de fusion est très élevé. Les couches obtenues selon ce procédé sont donc majoritairement voire totalement amorphes ou nano-cristallisées (la taille moyenne des grains cristallins étant de l'ordre du nanomètre), et des traitements thermiques se révèlent nécessaires pour obtenir le taux de cristallisation souhaité ou la taille de grains désirée, et donc la faible résistivité désirée.

Des traitements thermiques possibles consistent à réchauffer le substrat soit pendant le dépôt, soit à l'issue du dépôt, par exemple en sortie de ligne magnétron. La cristallisation est d'autant meilleure et la taille des grains est d'autant plus grande que la température du substrat est proche de la température de fusion du matériau constituant le film mince. Mais le plus généralement, des températures d'au moins 200°C ou 300°C sont nécessaires, ce qui n'est généralement pas possible pour des substrats organiques.

Le chauffage du substrat dans les lignes magnétron industrielles (pendant le dépôt) s'est toutefois révélé malaisé à mettre en oeuvre, en particulier car les transferts de chaleur sous vide, nécessairement de nature radiative, sont difficiles à maîtriser et impliquent un coût élevé dans le cas des substrats de grande taille, de plusieurs mètres de largeur. Dans le cas de substrats de verre de faible épaisseur, ce type de traitement implique souvent des risques de casse élevés. En outre, les couches d'argent déposées sur un substrat chaud ont tendance à former des couches discontinues, sous forme d'îlots, dont la résistivité est élevée.

Enfin, les couches d'argent déposées sur substrat chaud ou ayant subi un traitement thermique postérieur sont particulièrement rugueuses, ce qui les rend impropres à une utilisation en tant qu'électrode de dispositif OLED.

Le chauffage du substrat revêtu à l'issue du dépôt, par exemple en plaçant le substrat dans un four ou une étuve ou en soumettant le substrat au rayonnement infrarouge issu de dispositifs de chauffage conventionnels tels que des lampes infrarouge, présente également des inconvénients car ces différents procédés contribuent à chauffer sans discernement le substrat et la couche mince. Le chauffage du substrat à des températures supérieures à 150°C est susceptible de générer des casses dans le cas de substrats de grande taille (plusieurs mètres de large) car il est impossible d'assurer une température identique sur toute la largeur du substrat. Le chauffage des substrats ralentit également l'ensemble du procédé, car il est nécessaire d'attendre leur refroidissement complet avant d'envisager leur découpe ou leur stockage, qui a généralement lieu en empilant les substrats les uns sur les autres. Un refroidissement très contrôlé est en outre indispensable pour éviter la génération de contraintes au sein du verre, et donc la possibilité de casses. Un tel refroidissement très contrôlé étant très coûteux, le recuit n'est généralement pas suffisamment contrôlé pour éliminer les contraintes thermiques au sein du verre, ce qui génère un nombre accru de casses en ligne. Le recuit présente en outre l'inconvénient de rendre la découpe du verre plus difficile, les fissures ayant une tendance moins forte à se propager linéairement. Il a également été observé que les recuits classiques engendraient des défauts dans la couche d'argent, sous forme de « dendrites », probablement dues à la migration d'oxygène dans la couche, et particulièrement préjudiciables dans les applications OLED.

Le chauffage des substrats revêtus a lieu dans le cas où les vitrages sont bombés et/ou trempés, car un réchauffage du verre au-delà de sa température de ramollissement (généralement à plus de 600°C, voire 700°C pendant quelques minutes) est effectué. La trempe ou le bombage permet donc d'obtenir le résultat souhaité de cristallisation des couches minces. Il serait toutefois coûteux de soumettre à de tels traitements tous les vitrages dans le seul but d'améliorer la cristallisation des couches. En outre, les vitrages trempés ne peuvent plus être découpés, et certains empilements de couches minces ne supportent pas les températures élevées subies lors de la trempe du verre.

Il est également connu des demandes WO 2008/096089 et WO 2010/142926 de traiter thermiquement des empilements contenant une ou plusieurs couches d'argent à l'aide par exemple d'une flamme ou d'un rayonnement laser. Pour ce faire, le substrat revêtu de la couche d'argent défile sous un brûleur ou sous une ligne laser de façon à traiter l'intégralité de la surface. Ces procédés ne sont toutefois pas dénués d'inconvénients car ils peuvent engendrer des contraintes mécaniques au sein de la couche, susceptibles d'entraîner dans certains cas une délamination de celle-ci. FR2911130 décrit un traitement pour un substrat en verre ou plastique recouvert de couches minces dont au moins une couche d'argent avec une étape de traitement thermique de la couche d'argent par laser IR, induction, torche plasma ou flammage.

L'invention se propose d'obvier à l'ensemble de ces inconvénients, en proposant un procédé d'obtention d'un matériau selon les revendications.

Un traitement thermique selon les revendications permet de réduire la résistivité ou l'émissivité de la couche d'argent (généralement les deux propriétés), peut être réalisé sur des substrats en matière polymérique, et ne génère pas de défauts du type dendrites ou délamination.

On entend par lumière un rayonnement électromagnétique couvrant non seulement la lumière visible, mais aussi le domaine de l'ultraviolet et de l'infrarouge. Les longueurs d'onde émises par la source de lumière sont typiquement comprises dans un domaine allant de 200 nm à 3 µm. La lumière utilisée sera généralement décomposable en un spectre discret ou continu de plusieurs longueurs d'onde.

Le traitement thermique est de préférence mis en oeuvre en irradiant simultanément une partie de la surface de l'empilement, dont le plus petit côté a une longueur d'au moins 1 cm, notamment 5 cm, voire 10 cm et même 30 ou 50 cm.

La surface irradiée de manière simultanée représente de préférence au moins 10%, voire 20%, ou même 50% de la surface totale de l'empilement. Pour traiter la totalité de la surface, on peut alors traiter successivement les différentes parties à l'aide d'une même source de lumière, en prévoyant un déplacement relatif entre la source de lumière et le substrat. A titre d'exemple, la ou chaque source de lumière peut être fixe, le substrat venant défiler en regard. Alternativement, le substrat peut être fixe et la source de lumière peut être déplacée en regard du substrat.

Dans certains cas, le traitement thermique est de préférence mis en oeuvre en irradiant simultanément la totalité de la surface de l'empilement. C'est notamment le cas des substrats possédant une surface d'au plus 1 ou 2 m², en utilisant par exemple une seule source de lumière, ou de substrats de toute taille, en utilisant plusieurs sources de lumière.

L'amélioration des caractéristiques de cristallisation de l'argent due au traitement thermique permet également d'augmenter la transmission lumineuse du substrat revêtu, d'au moins 1%, notamment 2% absolus (il ne s'agit pas d'une augmentation relative). La transmission lumineuse est calculée selon la norme NF EN 410.

De préférence, la résistance carrée et/ou l'émissivité de l'empilement est diminuée d'au moins 10%, voire 15% ou même 20% par le traitement thermique. Il s'agit ici d'une diminution relative, par rapport à la valeur de la résistance carrée ou de l'émissivité avant traitement.

Le substrat est de préférence en verre ou en matière organique polymérique. Il est de préférence transparent, incolore (il s'agit alors d'un verre clair ou extra-clair) ou coloré, par exemple en bleu, gris ou bronze. Le verre est de préférence de type silico-sodo-calcique, mais il peut également être en verre de type borosilicate ou alumino-borosilicate. Les matières organiques polymériques préférées sont le polycarbonate, le polyméthacrylate de méthyle, le polyéthylène téréphtalate (PET), le polyéthylène naphtalate (PEN), ou encore les polymères fluorés tels que l'éthylène tétrafluoroéthylène (ETFE). Le substrat possède avantageusement au moins une dimension supérieure ou égale à 1 m, voire 2 m et même 3 m. L'épaisseur du substrat varie généralement entre 0,025 mm et 19 mm, de préférence entre 0,4 et 6 mm, notamment entre 0,7 et 2,1 mm pour un substrat en verre, et de préférence entre 0,025 et 0,4 mm, notamment entre 0,075 et 0,125 mm pour un substrat polymère. Le substrat peut être plan ou bombé, voire flexible.

Le substrat de verre est de préférence du type flotté, c'est-à-dire susceptible d'avoir été obtenu par un procédé consistant à déverser le verre fondu sur un bain d'étain en fusion (bain « float »). Dans ce cas, la couche à traiter peut aussi bien être déposée sur la face « étain » que sur la face « atmosphère » du substrat. On entend par faces « atmosphère » et « étain », les faces du substrat ayant été respectivement en contact avec l'atmosphère régnant dans le bain float et en contact avec l'étain fondu. La face étain contient une faible quantité superficielle d'étain ayant diffusé dans la structure du verre. Il peut également être obtenu par laminage entre deux rouleaux, technique permettant en particulier d'imprimer des motifs à la surface du verre.

Selon un premier mode de réalisation préféré, la ou chaque source de lumière comprend au moins une lampe flash, notamment à l'argon ou au xénon, la durée d'irradiation allant de 0,1 à 20 millisecondes, notamment de 0,5 à 5 millisecondes. De telles lampes se présentent généralement sous la forme de tubes en verre scellés et remplis d'un gaz rare, typiquement le xénon, l'argon, l'hélium ou le krypton, munis d'électrodes à leurs extrémités. Sous l'effet d'une impulsion électrique de courte durée, obtenue par décharge d'un condensateur, le gaz s'ionise et produit une lumière incohérente particulièrement intense. Le spectre d'émission comporte généralement au moins deux raies d'émission. Le condensateur est typiquement chargé à une tension de 500 à 5000 V. La densité d'énergie totale émise par les lampes flash, rapportée à la surface de la couche, est de préférence comprise entre 1 et 100 J/cm², notamment entre 5 et 30 J/cm², notamment entre 10 et 20 J/cm². Les très faibles durées d'irradiation ont pour conséquence que seule l'extrême surface du matériau est chauffée, ce qui présente un très net avantage, particulièrement lorsque le substrat est en matière polymérique.

Selon un deuxième mode de réalisation préféré, la ou chaque source de lumière comprend au moins une lampe à incandescence halogène, la durée d'irradiation allant de 0,1 à 100 secondes, notamment de 1 à 30 secondes. Les lampes se présentent typiquement sous la forme de tubes en verre contenant un filament de tungstène et un gaz halogéné, tel que l'iode et/ou le brome, à haute pression. La température atteinte par le matériau est de préférence comprise entre 400 et 700°C, notamment entre 500 et 650°C. La montée en température est très rapide, avec une vitesse allant de 10 à 150°C/s, avant d'atteindre un palier. L'augmentation de température du substrat peut être rendue plus rapide en plaçant ledit substrat sur un support absorbant la lumière émise par la lampe, par exemple un support en graphite.

L'empilement, avant ou après traitement thermique, comprend au moins une couche d'argent entre au moins deux couches.

L'empilement comprend de préférence, à partir du substrat, un premier revêtement comprenant au moins une première couche diélectrique, au moins une couche d'argent, éventuellement une couche de sur-bloqueur et un deuxième revêtement comprenant au moins une deuxième couche, notamment diélectrique. Notamment lorsque le substrat est en matière organique polymérique, par exemple flexible, ou lorsque le substrat est associé à un intercalaire de feuilletage, les premier et deuxième revêtements servent avantageusement de couche barrière à l'humidité et aux gaz.

De préférence, l'épaisseur physique d'au moins une, notamment de la ou de chaque couche d'argent est comprise entre 6 et 20 nm.

La couche de sur-bloqueur est destinée à protéger la couche d'argent pendant le dépôt d'une couche ultérieure (par exemple si cette dernière est déposée sous atmosphère oxydante ou nitrurante) et pendant un éventuel traitement thermique ultérieur.

La couche d'argent peut également être déposée sur et en contact avec une couche de sous-bloqueur. L'empilement peut donc comprendre une couche de sur-bloqueur et/ou une couche de sous-bloqueur encadrant la ou chaque couche d'argent.

Les couches de bloqueur (sous-bloqueur et/ou sur-bloqueur) sont généralement à base d'un métal choisi parmi le nickel, le chrome, le titane, le niobium, ou d'un alliage de ces différents métaux. On peut notamment citer les alliages nickel-titane (notamment ceux comprenant environ 50% en poids de chaque métal) ou les alliages nickel-chrome (notamment ceux comprenant 80% en poids de nickel et 20% en poids de chrome). La couche de sur-bloqueur peut encore être constituée de plusieurs couches superposées, par exemple, en s'éloignant du substrat, de titane puis d'un alliage de nickel (notamment un alliage nickel-chrome) ou l'inverse. Les différents métaux ou alliages cités peuvent également être partiellement oxydés, notamment présenter une sous-stoechiométrie en oxygène (par exemple TiOₓ ou NiCrOₓ).

Ces couches de bloqueur (sous-bloqueur et/ou sur-bloqueur) sont très fines, normalement d'une épaisseur inférieure à 1 nm, pour ne pas affecter la transmission lumineuse de l'empilement, et sont susceptibles d'être partiellement oxydées pendant le traitement thermique selon l'invention. D'une manière générale les couches de bloqueur sont des couches sacrificielles, susceptibles de capter l'oxygène provenant de l'atmosphère ou du substrat, évitant ainsi l'oxydation de la couche d'argent.

La première couche diélectrique est typiquement en oxyde (notamment en oxyde d'étain), ou de préférence en nitrure, notamment en nitrure de silicium. D'une manière générale, le nitrure de silicium peut être dopé, par exemple avec de l'aluminium ou du bore, afin de faciliter son dépôt par les techniques de pulvérisation cathodique. Le taux de dopage (correspondant au pourcentage atomique par rapport à la quantité de silicium) ne dépasse généralement pas 10%. La première couche diélectrique a pour fonction de protéger la couche d'argent des agressions chimiques ou mécaniques et influe également sur les propriétés optiques, notamment en réflexion, de l'empilement, grâce à des phénomènes interférentiels.

Le premier revêtement peut comprendre une couche diélectrique, ou plusieurs couches diélectriques, typiquement 2 à 3. Le deuxième revêtement peut comprendre une couche diélectrique, ou plusieurs couches diélectriques, typiquement 2 à 3. Ces couches diélectriques sont de préférence en un matériau choisi parmi les oxydes et/ou nitrures, éventuellement dopés, de silicium, titane, étain, zinc, magnésium, ou l'un quelconque de leurs mélanges ou solutions solides, par exemple un oxyde d'étain et de zinc, ou un oxyde de titane et de zinc. L'épaisseur physique de la couche diélectrique, ou l'épaisseur physique globale de l'ensemble des couches diélectriques, est de préférence comprise entre 15 et 300 nm, notamment entre 20 et 200 nm.

Le premier revêtement comprend de préférence, immédiatement sous la couche d'argent ou sous l'éventuelle couche de sous-bloqueur, une couche de mouillage dont la fonction est d'augmenter le mouillage et l'accrochage de la couche d'argent. L'oxyde de zinc, notamment dopé à l'aluminium, s'est révélé particulièrement avantageux à cet égard.

Le premier revêtement peut également contenir, directement sous la couche de mouillage, une couche de lissage, qui est un oxyde et/ou un nitrure mixte partiellement voire totalement amorphe (donc de très faible rugosité), dont la fonction est de favoriser la croissance de la couche de mouillage selon une orientation cristallographique préférentielle, laquelle favorise la cristallisation de l'argent par des phénomènes d'épitaxie. La couche de lissage est de préférence composée d'un oxyde mixte d'au moins deux métaux choisis parmi Sn, Zn, In, Ga, Sb, Si. Un oxyde préféré est l'oxyde d'étain et de zinc dopé à l'antimoine, ou un nitrure de silicium dopé au zirconium et à l'aluminium.

Dans le premier revêtement, la couche de mouillage ou l'éventuelle couche de lissage est de préférence déposée directement sur la première couche diélectrique. La première couche diélectrique est de préférence déposée directement sur le substrat. Pour adapter au mieux les propriétés optiques de l'empilement (notamment l'aspect en réflexion), la première couche diélectrique peut alternativement être déposée sur une autre couche en oxyde ou en nitrure, par exemple en oxyde de titane ou en nitrure de silicium.

Au sein du deuxième revêtement, la deuxième couche, est de préférence conductrice pour les applications OLED, et de préférence diélectrique pour les autres applications. La deuxième couche diélectrique est typiquement en oxyde (notamment en oxyde d'étain), ou de préférence en nitrure, notamment en nitrure de silicium.

La deuxième couche, qu'elle soit diélectrique ou non, peut être déposée directement sur la couche d'argent, ou de préférence sur un sur-bloqueur, ou encore sur d'autres couches en oxyde ou en nitrure, destinées à adapter les propriétés optiques de l'empilement. Par exemple, une couche d'oxyde de zinc, notamment dopé à l'aluminium, ou encore une couche d'oxyde d'étain, ou d'oxyde d'étain et de zinc peut être disposée entre un sur-bloqueur et la deuxième couche. L'oxyde de zinc, notamment dopé à l'aluminium, permet d'améliorer l'adhésion entre l'argent et les couches supérieures.

Ainsi, l'empilement traité selon l'invention comprend de préférence au moins une succession ZnO / Ag / ZnO. L'oxyde de zinc peut être dopé à l'aluminium. Une couche de sous-bloqueur peut être disposée entre la couche d'argent et la couche sous-jacente. Alternativement ou cumulativement, une couche de sur-bloqueur peut être disposée entre la couche d'argent et la couche sus-jacente.

Enfin, le deuxième revêtement peut être surmonté d'une surcouche destinée à protéger l'empilement contre toutes agressions mécaniques (rayures...) ou chimiques. Cette surcouche est généralement très fine pour ne pas perturber l'aspect en réflexion de l'empilement (son épaisseur est typiquement comprise entre 1 et 5 nm). Elle est de préférence à base d'oxyde de titane ou d'oxyde mixte d'étain et de zinc, notamment dopé à l'antimoine, déposé sous forme sous-stoechiométrique.

Lorsque l'empilement est destiné à être intégré dans un dispositif OLED, la dernière couche de l'empilement est de préférence en un oxyde transparent conducteur présentant un travail de sortie élevé, tel qu'un oxyde d'indium et d'au moins un élément choisi parmi l'étain et le zinc (couches ITO, IZO, ITZO). Dans l'architecture générale décrite ci-avant, cette dernière couche fait partie du deuxième revêtement et correspond de préférence à la « deuxième couche ».

L'empilement peut comprendre une ou plusieurs couches d'argent, notamment deux ou trois couches d'argent. Lorsque plusieurs couches d'argent sont présentes, l'architecture générale présentée ci-avant peut être répétée. Dans ce cas, le deuxième revêtement relatif à une couche d'argent donnée (donc situé au-dessus de cette couche d'argent) coïncide généralement avec le premier revêtement relatif à la couche d'argent suivante.

Quelques exemples non limitatifs d'empilement pouvant être traités selon l'invention sont décrits ci-après. Les couches sont indiquées dans l'ordre de dépôt à partir du substrat.
Empilement 1 : Si₃N₄ / SnZnOₓ / ZnO / Ag / Ti / ITO
Empilement 2 : Si₃N₄ / SnZnOₓ / ZnO / Ag / Ti / ZnO / SnZnOₓ / ZnO / Ag / Ti / ITO

Ces deux empilements sont particulièrement adaptés pour une application dans un dispositif OLED. L'empilement comprend un premier revêtement comprenant trois couches, un sur-bloqueur et un deuxième revêtement contenant une deuxième couche transparente et conductrice, ici en ITO. L'empilement 2 illustre un empilement à deux couches d'argent.

La rugosité RMS de l'empilement est de préférence d'au plus 2 nm, notamment 1 nm, aussi bien avant qu'après traitement.

Les matériaux revêtus des empilements qui suivent son particulièrement bien adaptés à une intégration dans des vitrages bas-émissifs.
Empilement 3 : Si₃N₄ / TiO₂ / (SnZnOₓ) / ZnO / Ag / Ti / ZnO / Si₃N₄ / Ti
Empilement 4 : TiO₂ / ZnO / Ag / ZnO / (TiO₂) / Si₃N₄ / ZnSn
Empilement 5 : (Si₃N₄) / TiO₂ / (NiCr) / Ag / NiCr / (ZnO) / SnO₂
Empilement 6 : SiNₓ / ZnO / Ag / NiCr / ZnO / Si₃N₄
Empilement 7 : Si₃N₄ / ZnO / Ag / Ti / ZnO / Si₃N₄ / ZnO / Ag / Ti / ZnO / Si₃N₄
Empilement 8 : Si₃N₄ / ZnO / Ag / Ti / ZnO / Si₃N₄ / ZnO / Ag / Ti / ZnO / Si₃N₄ / ZnO / Ag / Ti / ZnO / Si₃N₄

La ou chaque source de lumière peut être intégrée dans une ligne de dépôt de couches, par exemple une ligne de dépôt par pulvérisation cathodique assistée par champ magnétique (procédé magnétron), ou une ligne de dépôt chimique en phase vapeur (CVD), notamment assistée par plasma (PECVD), sous vide ou sous pression atmosphérique (APPECVD). La ligne comprend en général des dispositifs de manutention des substrats, une installation de dépôt, des dispositifs de contrôle optique, des dispositifs d'empilage. Les substrats défilent, par exemple sur des rouleaux convoyeurs, successivement devant chaque dispositif ou chaque installation.

La ou chaque source de lumière est de préférence située juste après l'installation de dépôt de la couche, par exemple à la sortie de l'installation de dépôt. Le substrat revêtu peut ainsi être traité en ligne après le dépôt de la couche, à la sortie de l'installation de dépôt et avant les dispositifs de contrôle optique, ou après les dispositifs de contrôle optique et avant les dispositifs d'empilage des substrats.

La ou chaque source de lumière peut aussi être intégrée à l'installation de dépôt. Par exemple, elle peut être introduite dans une des chambres d'une installation de dépôt par pulvérisation cathodique, notamment dans une chambre où l'atmosphère est raréfiée, notamment sous une pression comprise entre 10⁻⁶ mbar et 10⁻² mbar. La ou chaque source de lumière peut aussi être disposée en dehors de l'installation de dépôt, mais de manière à traiter un substrat situé à l'intérieur de ladite installation. Il suffit de prévoir à cet effet un hublot transparent aux longueurs d'onde du rayonnement utilisé, au travers duquel la lumière viendrait traiter la couche. Le hublot est de préférence en un matériau à faible dilatation thermique. Il est ainsi possible de traiter une couche (par exemple une couche d'argent) avant le dépôt subséquent d'une autre couche dans la même installation. Lorsqu'une couche absorbante est une surcouche, par exemple métallique, son oxydation lors du traitement peut être gênée dans le cas où le substrat est placé dans une chambre sous vide. Il est possible dans ce cas de traiter l'empilement dans une chambre spéciale, dans laquelle on contrôlerait l'atmosphère oxydante.

Que le dispositif de rayonnement soit en dehors de ou intégré à l'installation de dépôt, ces procédés « en ligne » sont préférables à un procédé en reprise dans lequel il serait nécessaire d'empiler les substrats de verre entre l'étape de dépôt et le traitement thermique.

Les procédés en reprise peuvent toutefois avoir un intérêt dans les cas où la mise en oeuvre du traitement thermique selon l'invention est faite dans un lieu différent de celui où est réalisé le dépôt, par exemple dans un lieu où est réalisée la transformation du verre. Le dispositif de rayonnement peut donc être intégré à d'autres lignes que la ligne de dépôt de couches. Il peut par exemple être intégré à une ligne de fabrication de vitrages multiples (doubles ou triples vitrages notamment), ou à une ligne de fabrication de vitrages feuilletés. Dans ces différents cas, le traitement thermique selon l'invention est de préférence réalisé avant la réalisation du vitrage multiple ou feuilleté.

Le dépôt de l'empilement sur le substrat peut être réalisé par tout type de procédé, en particulier des procédés générant des couches majoritairement amorphes ou nano-cristallisées, tels que le procédé de pulvérisation cathodique, notamment assisté par champ magnétique (procédé magnétron), le procédé de dépôt chimique en phase vapeur assisté par plasma (PECVD), le procédé d'évaporation sous vide, ou le procédé sol-gel.

L'empilement est de préférence déposé par pulvérisation cathodique, notamment assistée par champ magnétique (procédé magnétron).

Pour plus de simplicité, le traitement de la couche se fait de préférence sous air et/ou à pression atmosphérique. Il est toutefois possible de procéder au traitement thermique de la couche au sein même de l'enceinte de dépôt sous vide, par exemple avant un dépôt subséquent. Le traitement peut aussi être effectué sous une atmosphère contrôlée (argon, azote, oxygène...).

Le procédé selon l'invention peut être mis en oeuvre sur un substrat placé aussi bien horizontalement que verticalement. Il peut également être mis en oeuvre sur un substrat pourvu de couches minces sur ses deux faces, au moins une couche d'une des faces ou de chaque face étant traitée selon l'invention. Dans le cas où des couches minces déposées sur les deux faces du substrat sont traitées selon l'invention, il est possible de traiter lesdites couches minces de chaque face soit simultanément, soit successivement, par des techniques identiques ou distinctes, en particulier selon que la nature des couches traitées est identique ou distincte. Le cas où le traitement selon l'invention est réalisé simultanément sur les deux faces du substrat est donc bien compris dans la portée de l'invention.

L'invention a également pour objet un matériau susceptible d'être obtenu par le procédé selon l'invention, ainsi qu'un vitrage ou un dispositif OLED comprenant au moins un matériau selon l'invention.

Un tel vitrage est de préférence un vitrage multiple, comportant au moins deux feuilles de verre séparées par une lame de gaz, dans lequel l'empilement est disposé sur une face en contact avec ladite lame de gaz, notamment en face 2 par rapport à l'extérieur (c'est-à-dire sur la face du substrat en contact avec l'extérieur du bâtiment qui est en opposée à la face tournée vers l'extérieur) ou en face 3 (c'est-à-dire sur la face du deuxième substrat en partant de l'extérieur du bâtiment tournée vers l'extérieur).

L'invention est illustrée à l'aide des exemples de réalisation non limitatifs qui suivent.

On dépose par pulvérisation cathodique sur un substrat de verre silico-sodo-calcique clair commercialisé par la demanderesse sous la marque SGG Planilux® un empilement de couches minces Si₃N₄ / SnZnOₓ / ZnO / Ag / Ti / ZnO / SnZnOₓ / ZnO / Ag / Ti / ITO.

Les échantillons sont placés sous un réseau de lampes flash à l'argon placées dans une enceinte dont les parois internes réfléchissent la lumière. Sous l'effet d'une décharge électrique (maximum 2500 V), le substrat revêtu de son empilement est soumis à un flash intense d'une durée de 3 ms, dont la densité d'énergie peut être régulée de l'ordre de 10 à 25 J/cm².

Le tableau 1 ci-après indique, en fonction de la densité d'énergie :
- la baisse d'absorption lumineuse, notée ΔA et exprimée en % ; il s'agit d'une variation absolue,
- la baisse de résistance carrée, exprimée ΔR et exprimée en % ; il s'agit ici d'une variation relative.

**Tableau 1**

| Ex. | Energie (J/cm²) | ΔA (%) | ΔR (%) |
|---|---|---|---|
| A1 | 14 | -0,2 | -2 |
| A2 | 16 | -0,8 | -21 |
| A3 | 18 | -1,2 | -21 |
| A4 | 20 | -1,5 | -22 |
| A5 | 22 | -2,7 | -35 |

Ces résultats montrent qu'au-delà d'environ 15 J/cm², pour une durée d'illumination de 3 ms, les couches d'argent de l'empilement voient leurs caractéristiques de cristallisation très nettement améliorées, ce qui se traduit à la fois par une baisse de résistance carrée (et donc de résistivité) de l'empilement et par une diminution de l'absorption lumineuse, donc une augmentation de la transmission lumineuse.

Le même type d'empilements a également été traité thermiquement à l'aide de lampes à incandescence halogène. Pour ce faire, les échantillons sont placés sur des supports en graphite, en regard d'un réseau de lampes à incandescence halogène placées dans un caisson aux parois réfléchissantes. La température du support est mesurée à l'aide d'un pyromètre. Les échantillons sont soumis à une rampe de montée en température jusqu'à une température de pallier T donnée, laquelle est maintenue pendant un temps t donné.

Le tableau 2 ci-après indique pour chaque exemple :
- la vitesse de montée en température V, exprimée en °C/s,
- la température de palier T, exprimée en °C,
- le temps de maintien à la température de palier, noté t, exprimé en secondes,
- l'augmentation du facteur de transmission lumineuse (en absolu), notée ΔT et exprimée en %,
- la baisse de résistance carrée, exprimée ΔR et exprimée en % ; il s'agit ici d'une variation relative.

**Tableau 2**

| Ex. | V (°C/s) | T (°C) | t (s) | ΔT (%) | ΔR (%) |
|---|---|---|---|---|---|
| B1 | 20 | 500 | 30 | 1,1 | -10,2 |
| B2 | 20 | 600 | 30 | 1,0 | -10,1 |
| B3 | 20 | 600 | 60 | 1,4 | -10,6 |
| B4 | 35 | 700 | 30 | -0,7 | -8,3 |

En guise d'exemple comparatif, on fait subir à un substrat muni de l'empilement précédemment décrit un traitement classique de recuit en portant le substrat à une température de 300°C pendant 30 minutes. Le traitement a bien pour effet de réduire la résistance carrée de l'empilement, mais génère des défauts de type dendrites.

## Revendications

1. Procédé d'obtention d'un matériau comprenant un substrat revêtu sur au moins une partie d'au moins une de ses faces d'un empilement de couches minces comprenant au moins une couche d'argent entre au moins deux couches, ledit procédé comprenant une étape de dépôt dudit empilement puis une étape de traitement thermique, de sorte que la résistance carrée et/ou l'émissivité dudit empilement est diminuée d'au moins 5% en relatif, la ou chaque couche d'argent restant continue à l'issue du traitement, **caractérisé en ce que** ledit traitement thermique est mis en oeuvre en irradiant au moins une partie de la surface dudit empilement à l'aide d'au moins une source de lumière incohérente choisie parmi une source de lumière comprenant au moins une lampe flash et une source de lumière comprenant au moins une lampe à incandescence halogène pendant une durée d'irradiation allant de 0,1 milliseconde à 100 secondes.

2. Procédé selon la revendication précédente, tel que le traitement thermique est mis en oeuvre en irradiant simultanément une partie de la surface de l'empilement, dont le plus petit côté a une longueur d'au moins 1 cm, notamment 5 cm.

3. Procédé selon la revendication 1, tel que le traitement thermique est mis en oeuvre en irradiant simultanément la totalité de la surface de l'empilement.

4. Procédé selon l'une des revendications précédentes, tel que la ou chaque source de lumière est fixe, le substrat venant défiler en regard.

5. Procédé selon l'une des revendications précédentes, tel que le substrat est en verre ou en matière organique polymérique.

6. Procédé selon l'une des revendications précédentes, tel que la ou chaque source de lumière comprend au moins une lampe flash, la durée d'irradiation allant de 0,1 à 20 millisecondes, notamment de 0,5 à 5 millisecondes.

7. Procédé selon la revendication précédente, tel que la lampe flash est à l'argon ou au xénon.

8. Procédé selon l'une des revendications 1 à 7, tel que la densité d'énergie totale émise par les lampes flash, rapportée à la surface de la couche, est comprise entre 1 et 100 J/cm², notamment entre 5 et 30 J/cm².

9. Procédé selon l'une des revendications 1 à 5, tel que la ou chaque source de lumière comprend au moins une lampe à incandescence halogène, la durée d'irradiation allant de 0,1 à 100 secondes, notamment de 1 à 30 secondes.

10. Procédé selon l'une des revendications précédentes, tel que le dépôt du revêtement sur le substrat est réalisé par pulvérisation cathodique.

11. Procédé selon l'une des revendications précédentes, tel que l'empilement de couches minces comprend, à partir du substrat, un premier revêtement comprenant au moins une première couche diélectrique, au moins une couche d'argent, éventuellement une couche de sur-bloqueur, et un deuxième revêtement comprenant au moins une deuxième couche.

12. Procédé selon l'une des revendications précédentes, tel que l'épaisseur physique de la ou de chaque couche d'argent est comprise entre 6 et 20 nm.

## Patentansprüche

1. Verfahren zum Erhalten eines Materials, das ein Substrat umfasst, das auf mindestens einem Teil mindestens einer seiner Seiten mit einem Stapel dünner Schichten überzogen ist, der mindestens eine Silberschicht zwischen mindestens zwei Schichten umfasst, wobei das Verfahren einen Schritt des Aufbringens des Stapels und dann einen Schritt des Wärmebehandelns umfasst, so dass der Flächenwiderstand und/oder die Emissivität des Stapels relativ um mindestens 5 % verringert wird, wobei die oder jede Silberschicht nach der Behandlung durchgängig bleibt, **dadurch gekennzeichnet, dass** die Wärmebehandlung ausgeführt wird, indem mindestens ein Teil der Oberfläche des Stapels mithilfe mindestens einer inkohärenten Lichtquelle, die unter einer Lichtquelle mit mindestens einer Blitzlampe und einer Lichtquelle mit mindestens einer Halogenglühlampe ausgewählt ist, während einer Bestrahlungsdauer zwischen 0,1 Millisekunde und 100 Sekunden bestrahlt wird.

2. Verfahren nach dem vorhergehenden Anspruch, wobei die Wärmebehandlung ausgeführt wird, indem gleichzeitig ein Teil der Oberfläche des Stapels bestrahlt wird, dessen kleinste Seite eine Länge von mindestens 1 cm, insbesondere 5 cm aufweist.

3. Verfahren nach Anspruch 1, wobei die Wärmebehandlung ausgeführt wird, indem gleichzeitig die gesamte Oberfläche des Stapels bestrahlt wird.

4. Verfahren nach einem der vorhergehenden Ansprüche, wobei die oder jede Lichtquelle stationär ist und das Substrat davor durchläuft.

5. Verfahren nach einem der vorhergehenden Ansprüche, wobei das Substrat aus Glas oder aus organischem Polymermaterial besteht.

6. Verfahren nach einem der vorhergehenden Ansprüche, wobei die oder jede Lichtquelle mindestens eine Blitzlampe umfasst, wobei die Bestrahlungsdauer zwischen 0,1 und 20 Millisekunden, insbesondere zwischen 0,5 und 5 Millisekunden beträgt.

7. Verfahren nach dem vorhergehenden Anspruch, wobei die Blitzlampe eine Argon- oder Xenonlampe ist.

8. Verfahren nach einem der Ansprüche 1 bis 7, wobei die von den Blitzlampen abgestrahlte Gesamtenergiedichte bezogen auf die Oberfläche der Schicht zwischen 1 und 100 J/cm², insbesondere zwischen 5 und 30 J/cm² beträgt.

9. Verfahren nach einem der Ansprüche 1 bis 5, wobei die oder jede Lichtquelle mindestens eine Halogenglühlampe umfasst, wobei die Bestrahlungsdauer zwischen 0,1 und 100 Sekunden, insbesondere zwischen 1 und 30 Sekunden beträgt.

10. Verfahren nach einem der vorhergehenden Ansprüche, wobei der Überzug durch Kathodenzerstäubung auf das Substrat aufgebracht wird.

11. Verfahren nach einem der vorhergehenden Ansprüche, wobei der Stapel dünner Schichten, ausgehend vom Substrat, einen ersten Überzug, der mindestens eine erste dielektrische Schicht, mindestens eine Silberschicht, gegebenenfalls eine obere Blockerschicht umfasst, und einen zweiten Überzug, der mindestens eine zweite Schicht umfasst, aufweist.

12. Verfahren nach einem der vorhergehenden Ansprüche, wobei die physische Dicke der oder jeder Silberschicht zwischen 6 und 20 nm beträgt.

## Claims

1. A process for obtaining a material comprising a substrate coated on at least one portion of at least one of its faces with a stack of thin layers comprising at least one silver layer between at least two layers, said process comprising a step of depositing said stack then a heat treatment step, so that the sheet resistance and/or the emissivity of said stack is reduced by at least 5% in relative terms, the or each silver layer remaining continuous at the end of the treatment, wherein said heat treatment is carried out by irradiating at least one portion of the surface of said stack using at least one incoherent light source selected from a light source comprising at least one flash lamp and a light source comprising at least one halogen incandescent light for an irradiation time ranging from 0.1 millisecond to 100 seconds.

2. The process as claimed in the preceding claim, wherein the heat treatment is carried out by simultaneously irradiating a portion of the surface of the stack, the smallest side of which has a length of at least 1 cm, in particular 5 cm.

3. The process as claimed in claim 1, wherein the heat treatment is carried out by simultaneously irradiating the whole of the surface of the stack.

4. The process as claimed in one of the preceding claims, wherein the or each light source of light is fixed, the substrate running in face of it

5. The process as claimed in one of the preceding claims, wherein the substrate is made of glass or of a polymeric organic material.

6. The process as claimed in one of the preceding claims, wherein the or each light source comprises at least one flash lamp, the irradiation time ranging from 0.1 to 20 milliseconds, in particular from 0.5 to 5 milliseconds.

7. The process as claimed in the preceding claim, wherein the flash lamp is an argon or xenon flash lamp.

8. The process as claims in one of claim 1 to 7, wherein the total energy density emitted by the flash lamps, relative to the surface area of the layer, is between 1 and 100 J/cm², in particular between 5 and 30 J/cm².

9. The process as claimed in one of claims 1 to 5, wherein the or each light source comprises at least one halogen incandescent lamp, the irradiation time ranging from 0.1 to 100 seconds, in particular from 1 to 30 seconds.

10. The process as claimed in one of the preceding claims, wherein the deposition of the coating on the substrate is carried out by sputtering.

11. The process as claimed in one of the preceding claims, wherein the stack of thin layers comprises, starting from the substrate, a first coating comprising at least one first dielectric layer, at least one silver layer, optionally an overblocker layer, and a second coating comprising at least a second layer.

12. The process as claimed in one of the preceding claims, wherein the physical thickness of the or of each silver layer is between 6 and 20 nm.
